Europäisches Patentamt

European Patent Office

Office européen des brevets

(11) Veröffentlichungsnummer: **0 286 918 B1**

## (12) EUROPÄISCHE PATENTSCHRIFT

(45) Veröffentlichungstag der Patentschrift: **03.06.92**

(51) Int. Cl.⁵: **H01L 31/18**, H01L 27/14

(21) Anmeldenummer: **88105204.7**

(22) Anmeldetag: **30.03.88**

(54) Verfahren zur Herstellung von in Reihe verschalteten Dünnschicht-Solarzellen.

(30) Priorität: **14.04.87 DE 3712589**

(43) Veröffentlichungstag der Anmeldung:
**19.10.88 Patentblatt 88/42**

(45) Bekanntmachung des Hinweises auf die
Patenterteilung:
**03.06.92 Patentblatt 92/23**

(84) Benannte Vertragsstaaten:
**CH DE ES FR GB IT LI**

(56) Entgegenhaltungen:
EP-A- 0 193 820
EP-A- 0 201 312
DE-A- 2 839 038
FR-A- 2 436 648
GB-A- 2 184 601

APPLIED PHYSICS A: SOLIDS AND SURFA-
CES Band A41, Nr. 4,Dezember 1986, Seiten
267-274, Berlin, D; S. NAKANO et al.: "High
Performance a-Si Solar Cells and New Fabrication Methods for a-Si Solar Cells"

PHILIPS JOURNAL OF RESEARCH Band 41,
Nr. 1, 1986, Seiten 77-81, Eindhoven, NL; J.
HAISMA et al.: "Resistance modification of
indium oxide layers by laser annealing and

ion bombardment respectively"

PATENT ABSTRACTS OF JAPAN Band 10, Nr.
50, (E-384)(2107) 1985; & JP-A-60206077

(73) Patentinhaber: **Nukem GmbH**
**Rodenbacher Chaussee 6 Postfach 11 00 80**
**W-6450 Hanau 11(DE)**

(72) Erfinder: **Wörner, Jörg, Dr.**
**Philipp-Reis-Strasse 16**
**W-6451 Grosskrotzenburg(DE)**

(74) Vertreter: **Stoffregen, Hans-Herbert, Dr.**
**Dipl.-Phys. et al**
**Patentanwälte Strasse & Stoffregen Salz-**
**strasse 11a Postfach 2144**
**W-6450 Hanau/Main 1(DE)**

**Beschreibung**

Die Erfindung bezieht sich auf ein Verfahren zur Herstellung von in Reihe verschalteten auf einem gemeinsamen Substrat angeordneten Dünnschicht-Solarzellen, wobei auf dem Substrat großflächig nacheinander eine erste Elektrodenschicht, mindestens eine Schicht aus Halbleitermaterial und eine zweite Elektrodenschicht aufgebracht werden und wobei die erste Elektrodenschicht vor Aufbringen der weiteren Schicht strukturiert wird.

Um von Anwendungen geforderte Spannungsbereiche von 12 bis 15 Volt befrieden zu können, müssen Solarzellen in Reihe verschaltet werden. Dabei bieten Dünnschicht-Solarzellen im Vergleich zur Verschaltung diskreter kristalliner Siliziumscheiben den wesentlichen Vorteil, daß eine Herstellung durch großflächige Schichten auf Substraten durch Sprüh-, Aufdampf und Plasmaentladungprozesse möglich ist, wobei dann diese Schichten in einzelne Solarzellenbereiche aufgeteilt und verschaltet werden.

Aus der DE-A 28 39 038 ist ein Verfahren Zur Herstellung einer Reihenschaltungsanordnung von Dünnschicht-Solarzellen bekannt. Zur Herstellung wird zunächst eine Fläche eines Substrats vollständig mit einem Film aus einem durchsichtigen elektrisch leitfähigen Material sowie einem darüberliegenden zweiten Film aus mindestens einem Halbleitermaterial überzogen, um anschließend bestimmte Abschnitte der Filme selektiv abzutragen und zu entfernen, so daß auf dem Substrat zahlreiche auf Abstand angeordnete Sperrschicht-Photozellen ausgebildet sind. Anschließend wird großflächig eine Deckschicht als zweite Elektrodenschicht aufgebracht, die sodann in unmittelbarer Nachbarschaft zu den Stellen, an denen die selektive Materialabtragung von der ersten Elektrodenschicht und der darüberliegenden Halbleiterschichten ausgeführt wurden, ebenfalls unterbrochen werden, um die erforderliche Verschaltung zu ermöglichen.

Aus der EP-A-0 193 820 ist ein Verfahren zur Herstellung von Halbleiteranordnungen bekannt, bei dem auf einem Substrat eine erste Elektrodenschicht aufgebracht und ein Teil von dieser entfernt wird. Anschließend wird eine lift-off Schicht und eine Halbleiterschicht amorphen Materials aufgebracht, um sodann durch Entfernen der lift-off Schicht die Halbleiterschicht zu strukturieren. Nachfolgend wird eine weitere lift-off Schicht in dem Bereich angeordnet, wo Material einer anschließend aufzubringenden zweiten Elektrodenschicht nicht gewünscht wird.

Die EP-A 0 201 312 bezieht sich auf ein Verfahren zur Verschaltung von Solarzellen, die auf einem gemeinsamen Substrat angeordnet sind. Zur Verschaltung der Solarzellen gehen von diskreten ersten Elektrodenabschnitten streifenförmige leitende Balken aus, die punktuell mit diskreten zweiten Elektrodenabschnitten verbunden werden. Zwischen den ersten und zweiten Elektrodenabschnitten befindet sich eine Strahlungsenergie in elektrische Energie umwandelnde Halbleiterschicht.

Aufgabe der vorliegenden Erfindung ist es, ein Verfahren der eingangs genannten Art so auszubilden, daß die zum Verschalten von auf einem gemeinsamen Substrat angeordneten Dünnschicht-Solarzellen erforderliche Strukturierung herstellungstechnisch vereinfacht wird und im wesentlichen ohne Beschädigung der einzelnen Schichten erfolgen kann und ohne daß nach dem Stand der Technik bekannte Hilfsschichten erforderlich sind. Auch soll die Möglichkeit geschaffen werden, die Verbindungsbereiche zwischen den einzelnen Elektrodenschichten möglichst schmal auszubilden, so daß eine optimale Ausnutzung des photoaktiven Materials ermöglicht wird.

Die Aufgabe wird durch die dem Kennzeichen des Anspruchs 1 zu entnehmende Maßnahmen gelöst.

Weitere Ausgestaltungen der erfindungsgemäßen Lehre ergeben sich aus den Ansprüchen 2 - 9 und den diesen zu entnehmenden Merkmalen -für sich und/oder in Kombination-.

Dabei ist ganz allgemein zu bemerken, daß unter Aufbringen dabei nicht nur z. B. das Abscheiden von Material zu verstehen ist, sondern gegebenenfalls auch ein Nachbehandeln, Konditionieren oder Optimieren z.B. des Flächenwiderstandes oder der Transparenz zu verstehen. Selbstverständlich kann man unter Aufbringen aber auch nur das Anordnen der Schicht auf dem Substrat verstehen.

Die Erfindung wird nachstehend anhand von in der Zeichnung dargestellten bevorzugten Ausführungsbeispielen näher erläutert, anhand deren sich weitere Einzelheiten, Vorteile und Merkmale ergeben.

Es zeigen:

Fig. 1    in schematischer Darstellung den Ablauf eines ersten Verfahrens zur Herstellung von in Reihe verschlateten Dünnschicht-Solarzellen,

Fig. 2    einen schematischen Prozeßablauf eines zweiten Verfahrens,

Fig. 3    eine Prinzipdarstellung zur Herstellung einer Strukturierung und

Fig. 4    eine rein schematische und perspektivische Darstellung eines Dünnschichtsolarzellenverbandes.

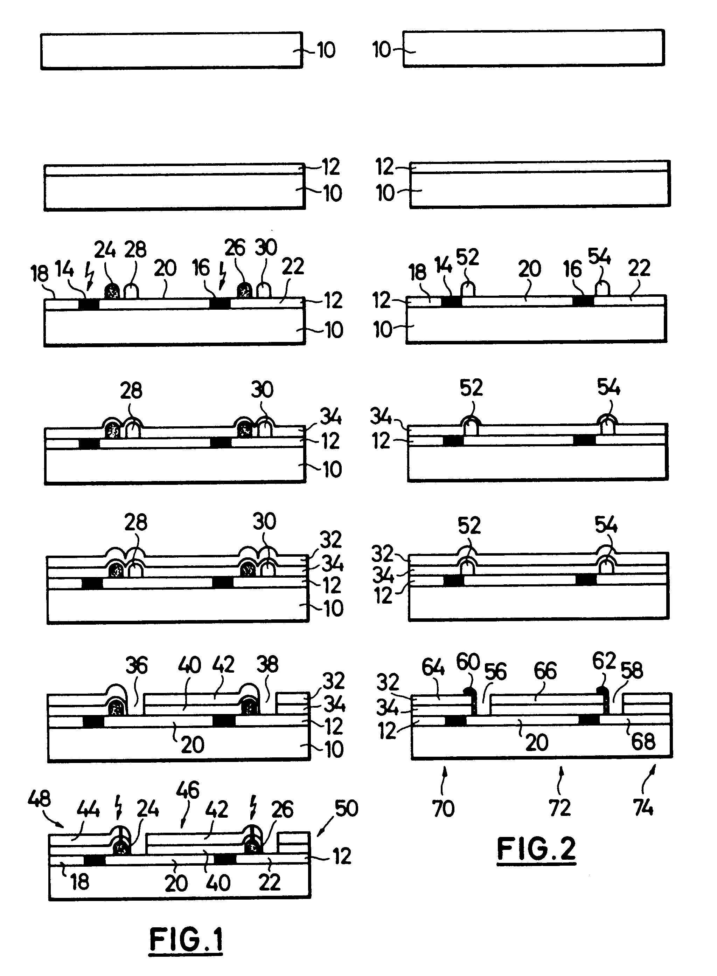

In Fig. 1 soll der Ablauf eines Verfahrens zur Herstellung von in Reihe verschalteten Dünnschicht-Solarzellen prinzipiell dargestellt werden. Auf einem Substrat (10) wird großflächig eine erste Elektrodenschicht (12), die vorzugsweise aus einem transparenten leitenden Oxid (TCO) wie ITO, Zinnoxid oder Indiumoxid besteht, aufgebracht. Nachdem die erste Elektrodenschicht (12) aufgetragen worden ist, werden entsprechend der gewünschten Struktur zueinander beabstandete stegförmige Bereiche (14) und (16) in der Elektrodenschicht (12) ausgebildet, die eine elektrische Trennung zwischen den zwischen diesen liegenden Bereichen (18), (20) und (22) bewirken. Dabei verlaufen die Stege (14) und (16) parallel zueinander und von Seite zu Seite des Substrats (10), also in die Zeichenebene hinein. Die Stege (14) und (16) werden im Ausführungsbeispiel durch Funkenerosion ausgebildet. Hierdurch erfolgt kein Materialabtrag, vielmehr wird durch Erwärmen und anschließendes schnelles Abkühlen bzw. Abschrecken eine Umwandlung des elektrisch leitenden Materials in ein hochohmiges Material bewirkt. Selbstverständlich besteht auch die Möglichkeit, in den Stegen (14) und (16) das Material der Elektrodenschicht (12) abzutragen. Vorzugsweise gleichzeitig zur Ausbildung der isolierenden Bereiche (14) und (16) werden parallel zu diesen linienförmig Pasten (24), (26) und (28), (30) aufgetragen, die unterschiedliche Aufgaben zu erfüllen haben. Dabei werden die Pasten (24), (26) und (28) und (30) jeweils auf einer -im Ausführungsbeispiel der linken- Seite der Bereiche (18), (20) und (22) der Elektrodenschicht (12) benachbart zu den Unterbrechungen (14) und (16) verlaufend angeordnet.

Die Verbindungsstreifen oder -balken (24) und (26), die auch als stitch-bars bezeichnet werden, haben die Aufgabe, bei einem fertiggestellten Dünnschichtsolarzellenverband die elektrisch leitende Verbindung zwischen der ersten Elektrodenschicht (12) und einer zweiten Elektrodenschicht (32) derart herzustellen, daß die einzelnen Dünnschicht-Solarzellen in Reihe verschaltet sind. Die Strukturierungsstreifen oder -balken (28) und (30), die auch als lift-off-bars zu bezeichnen sind, sollen dagegen die Strukturierung der anschließend aufzubringenden Halbleiterschicht (34) und die zweite Elektrodenschicht (32) herbeiführen. Die Breite der Streifen (24), (26), (28) und (30) beträgt jeweils ca. 50-200 $\mu$m bei einer Höhe von vorzugsweise 5-10$\mu$m, gegebenenfalls 20$\mu$m.

Als Material für die Verbindungsstreifen oder -balken (24) und (26) ist insbesondere eine Einbrennsilberpaste mit einem Feststoffgehalt von 80-85 Gew% zu nennen, die eine Einbrenntemperatur von 400-460°C aufweist. Hierdurch ergibt sich der Vorteil, daß das Substrat (10) nicht verzogen und die Elektrodenschicht (12), sofern diese aus TCO, insbesondere ITO besteht, thermisch kaum belastet wird.

Als Material für die Strukturierungsbalken (28) und (30) (für die folgenden Schichten) ist insbesondere eine Paste wie $TiO_2$ mit einem Feststoffgehalt

von 20% zu nennen, ebenfalls bei verwendetem TCO als Elektrodenschichtmaterial.

Nachdem die Strukturierung der ersten Elektrodenschicht (12) erfolgt und die linienförmigen vorzugsweise aus Pasten bestehenden Materialien (24), (26), (28) und (30) aufgetragen worden sind, wird großflächig die Halbleiterschicht (34) aufgebracht. Dabei ist die Halbleiterschicht (34) im eigentlichen Sinne mehrschichtig aufgebaut, damit durch Lichteinfall Ladungsträger erzeugt und zu den Elektroden abgeführt werden. Die Halbleiterschicht (34) sowie die zweite Elektrodenschicht (32) werden erwähntermaßen großflächig über die gesamte erste Elektrodenschicht (12) aufgetragen, decken demzufolge auch die Materialien (24), (26), (28) und (30) ab. Sodann können bei geeigneten Materialien die lift-off-bars (28) und (30) durch z.B. Einwirkung von Ultraschall entfernt werden, wodurch auch die darüberliegenden Bereiche der Halbleiterschicht (34) und der zweiten Elektrodenschicht (32) entfernt werden. Es bilden sich demzufolge Freiräume (36) und (38) aus, die eine Trennung der Halbleiterschichten (34) und der zweiten Elektrodenschicht (32) in diskrete Bereiche hervorrufen, die einzelne Dünnsicht-Solarzellen bilden. In der Zeichnung bilden demzufolge der Abschitt (20) der ersten Elektrodenschicht mit dem Abschnitt (40) der Halbleiterschicht (34) und dem Abschnitt (42) der zweiten Elektrodenschicht (32) eine einzelne Dünnschicht-Solarzelle. Um die Ladungsträger abzuleiten und die einzelnen nebeneinanderliegenden Dünnschicht-Solarzellen in Reihe zu verschalten, erfolgt in einem letzten Verfahrensschritt eine Kontaktierung zwischen der Elektrodenschicht (12) bzw. den Bereichen (18), (20) und (22) und den entsprechend zugeordneten Bereichen (42) und (44) der zweiten Elektrodenschicht. Diese Kontaktierung kann vorzugsweise ebenfalls durch Funkenerosion dadurch erfolgen, daß die stitch-bars (24) und (26) zu den Bereichen (42) und (44) durchkontaktiert werden. Hierdurch erfolgt eine Reihenschaltung mit der aus den Schichten (20), (40) und (42) aufgebauten mittleren Solarzelle (46) mit den benachbarten Solarzellen (48) bzw. (50).

Selbstverständlich kann der Aufbau einer jeden Solarzelle dahingehend geändert werden, daß die Halbleiterschicht (34) mehrschichtig ausgebildet ist oder z.B. zwischen der zweiten Elektrodenschicht (32) und der darunterliegenden Halbleiterschicht (34) eine weitere nicht dargestellte Zwischenschicht wie z.B. $SnO_x$-Schicht angeordnet ist, die zur Reflektion von Infrarotstrahlung dient, um ein Aufheizen des Dünnschichtsolarzellenverbandes zu unterbinden.

In Fig. 2 ist ein Verfahren zur Herstellung eines Dünnschichtsolarzellenverbandes beschrieben, wobei für gleiche Elemente gleiche Bezugzeichen benutzt werden.

Entsprechend dem Prozeß nach Fig. 1 erfolgt die Strukturierung der ersten Elektrodenschicht (12) vor Aufbringen der weiteren Schichten, also der Halbleiterschicht (34) und der zweiten Elektrodenschicht (32). Dabei können die die Bereiche (18), (20) und (22) elektrisch trennenden Stege (14) und (16) ebenfalls durch Materialumwandlung oder aber auch durch mechanisches Abtragen ausgebildet werden. Sodann werden in unmittelbarer Nachbarschaft zu den Stegen (14) und (16) lift-off-bars (52) und (54) auf den Bereichen (20) und (22) aufgetragen, die den lift-off-bars (28) und (30) nach Fig. 1 entsprechen. Anschließend erfolgt entsprechend der Beschreibung nach Fig. 1 das großflächige Auftragen der Halbleiterschicht (34) und der zweiten Elektrodenschicht (32) mit gegebenenfalls zuvor anzuordnender Zwischenschicht. Schließlich werden die lift-off-bars (52) und (54) entfernt, um die Strukturierung der Halbleiterschicht (34) und der zweiten Elektrodenschicht (32) zu erzielen. Anschließend können in die sich ausgebildeten Freiräume (56) und (58) z.B. im Siebdruckverfahren Leitpasten (60) und (62) eingebracht werden, die eine Verbindung zwischen dem Bereich (64) der zweiten Elektrodenschicht (32) mit dem Bereich (20) der ersten Elektrodenschicht (12) bzw. zwischen dem Bereich (66) und dem Bereich (68) herstellt, um die teilweise dargestellten einzelnen Dünnschicht-Solarzellen (70), (72) und (74) in Reihe zu verschalten.

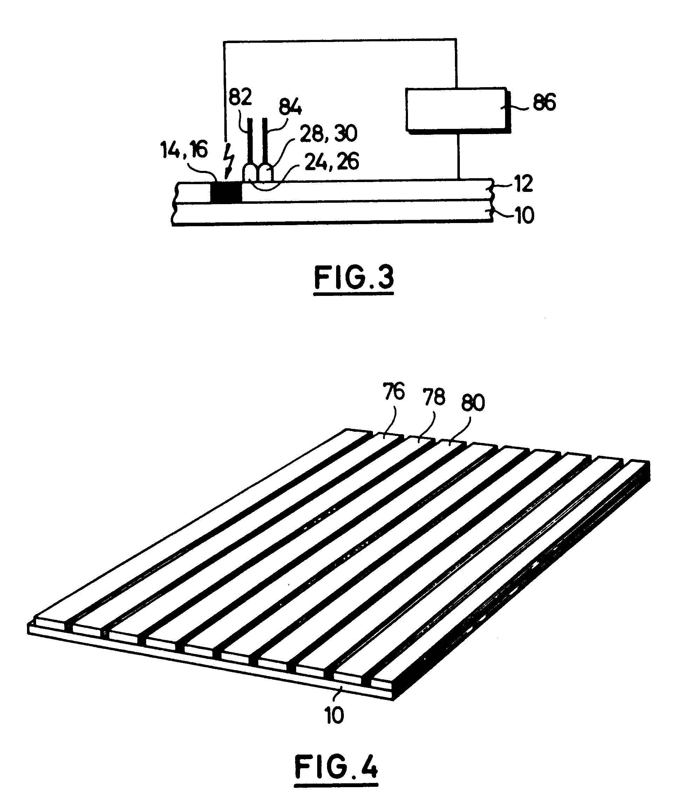

In Fig. 4 ist ein Dünnschichtsolarzellenverband rein schematisch und in perspektivischer Darstellung wiedergegeben, um zu verdeutlichen, daß durch die zuvor beschriebenen Verfahrensschritte auf dem Substrat (10) eine Vielzahl von parallel verlaufenden Dünnschicht-Solarzellen angeordnet sind, von denen einige beispielhaft mit den Bezugszeichen (76), (78) und (80) bezeichnet sind. Die parallel verlaufenden Dünnschicht-Solarzellen (76), (78) und (80) sind in Reihe verschaltet, damit der Dünnschichtsolarzellenverband die gewünschte Spannung liefern kann. Um die einzelnen Solarzellen (76), (78), (80) herzustellen, kann vorzugsweise ein Werkzeug Verwendung finden, das der Fig. 3 rein schematisch zu entnehmen ist.

Man erkennt, daß die auf dem Substrat (10) angeordnete erste Elektrodenschicht (12) vorzugsweise aus TCO mittels Funkenerosion strukturiert wird, um die streifenförmigen Bereiche (14) bzw. (16) auszubilden. Gleichzeitig weist das Werkzeug Düsen (82) und (84) auf, über die die Pastenstreifen (24), (26) bzw. (28), (30) parallel verlaufend neben den Bereichen (14) und (16) auf die Oberfläche der Elektrodenschicht (12) aufgetragen werden. Bei dem Streifenmaterial (24), (26) handelt es sich erwähntermaßen vorzugsweise um Einbrennsilberpasten, wohingegen das Material der Streifen (28) und (30) eine Paste mit vorzugsweise $TiO_2$ ist.

Die Funkenerosion selbst ist durch den Blitz oberhalb der Bereiche (14), (16) angedeutet. Die Entladung erfolgt über eine skalpellförmig ausgebildete Elektrode. Damit die Funkenentladung erfolgt, muß ein Stromgenerator (86) vorgesehen sein, dessen einer Pol mit der Oberfläche der Elektrodenschicht (12) und dessen anderer Pol mit der nicht dargestellten skalpellförmig ausgebildeten Elektrode verbunden ist.

Das der Fig. 3 zu entnehmende Werkzeug kann dahingehend modifiziert werden, daß es als Mehrfachwerkzeug ausgebildet wird, d.h. zur Herstellung des Dünnschichtsolarzellenverbandes nach Fig. 4 können mehrere Skalpellelektroden und Düsen (82) und (84) nebeneinander angeordnet werden, um gleichzeitig die Struktur von mehreren parallel zueinander angeordneten Dünnschichtsolarzellen vorzugeben.

## Patentansprüche

1. Verfahren zur Herstellung von in Reihe verschalteten auf einem gemeinsamen Substrat (10) angeordneten DünnschichtSolarzellen (46, 48, 50), wobei auf dem Substrat großflächig nacheinander eine erste Elektrodenschicht (12), mindestens eine Schicht (34) aus Halbleitermaterial und eine zweite Elektrodenschicht (32) aufgebracht werden und wobei die erste Elektrodenschicht vor Aufbringen der weiteren Schicht strukturiert wird,
**dadurch gekennzeichnet,**
daß gleichzeitig mit oder nach der Strukturierung der ersten Elektrodenschicht (12) auf dieser Schicht parallel zu deren Struktur ein Streifen (28, 30) aus weiterem Strukturmaterial und wahlweise ein Streifen (24, 26)aus elektrisch leitfähigem Material aufgebracht werden, die von den weiteren Schichten (32, 34) abgedeckt werden, und daß dann der Streifen aus dem weiteren Strukturmaterial mit der darauf befindlichen mindestens einen Halbleiterschicht (34) und der zweiten Elektrodenschicht (32) entfernt wird, und daß schließlich zur Verschaltung der Dünnschicht-Solarzellen eine Verbindung der zweiten Elektrodenschicht mit der ersten Elektrodenschicht oder dem wahlweise vorgesehenen Streifen aus elektrisch leitfähigem Material durch die weiteren Schichten hindurch hergestellt wird.

2. Verfahren nach Anspruch 1,
**dadurch gekennzeichnet,**
daß das elektrisch leitfähige Material eine Paste wie z.B. Silbereinbrennpaste mit einer Einbrenntemperatur von 400-460 °C ist.

3. Verfahren nach Anspruch 1,

**dadurch gekennzeichnet,**
daß das die Strukturierung der Halbleiterschicht (34) und der zweiten Elektrodenschicht (32) bewirkende Strukturmaterial eine hochohmige Paste ist, die vorzugsweise durch Ultraschall derart in Schwingung gesetzt wird, daß die darüberliegenden Bereiche der Schicht des Halbleitermaterials und der zweiten Elektrodenschicht zerstört werden.

4. Verfahren nach Anspruch 1,
**dadurch gekennzeichnet,**
daß das elektrisch leitfähige Material zu der zweiten Elektrodenschicht (32) erosiv durchkontaktiert wird.

5. Verfahren nach Anspruch 1,
**dadurch gekennzeichnet,**
daß das elektrisch leitfähige Material und das die Strukturierung der Schicht (34) des Halbleitermaterials und der zweiten Elektrodenschicht (32) bewirkende Strukturmaterial nebeneinander, gegebenenfalls teilweise überlappend auf der ersten Elektrodenschicht und vorzugsweise gleichzeitig aufgebracht werden.

6. Verfahren nach Anspruch 1,
**dadurch gekennzeichnet,**
daß die erste Elektrodenschicht (12) aus einem transparenten leitenden Oxid besteht und durch Schmelzen parallel verlaufender Streifenbereiche (14, 16) und unmittelbar sich anschließendes Abkühlen strukturiert wird.

7. Verfahren nach zumindest einem der vorhergehenden Ansprüche,
**dadurch gekennzeichnet,**
daß die Strukturierung der ersten Elektrodenschicht (12) und das Auftragen der die Strukturierung des anschließend aufzutragenden Strukturmaterials gleichzeitig mit einem Werkzeug (82, 84) erfolgt.

8. Verfahren nach Anspruch 1,
**dadurch gekennzeichnet,**
daß als weiteres Strukturmaterial TiO$_2$ Paste verwendet wird.

9. Verfahren nach Anspruch 1,
**dadurch gekennzeichnet,**
daß die Strukturierung der ersten Elektrodenschicht (12) durch Funkenerosion erfolgt.

**Claims**

1. A method for producing thin-film solar cells (46, 48, 50), connected in series and arranged on a common substrate (10), said substrate being covered sequentially with a first electrode layer (12), at least one layer (34) made of semiconducting material and second electrode layer (32), said first electrode layer being structured prior to depositing said any further layers,
**characterized in that,**
simultaneously with or subsequent to the structuring of said first electrode layer (12) a strip (28, 30) made of additional structural material and, as suitable, a striß (24, 26) made of electrically conductive material are deposited on said first layer parallel to its structure, said strips which are covered by the subsequent layers (32, 34), subsequently said strip made of said additional structural material is removed from the additional structural material together with the superimposed at least one semiconductive layer (34) and the second electrode layer (32), and that finally the thin-film solar cells are circuited by connecting the second electrode layer with the first electrode layer or the optionally provided strip of electrically conductive material trough the additional layers.

2. A method according to Claim 1,
**wherein**
the electrically conductive material is a paste as a bakable silver paste with a baking temperature of 400-460°C.

3. A method according to Claim 1,
**wherein**
the structural material structuring the semiconductor layer (34) and the second electrode layer (32) is a paste of high-resistivity, said paste is preferably caused to oscillate by ultrasonic means so as to destroy the above laying-areas of said semiconductive layer and said second electrode layer.

4. A method according to Claim 1,
**wherein**
said electrically conductive material and said second electrode layer (32) is through hole plated by erosive means.

5. A method according to Claim 1,
**wherein**
said electrically conductive material and said structural material structuring said semiconductor material (34) and said second electrode layer (32), partially overlapping if necessary, are arranged parallel on the first electrode layer, preferably simultaneously.

6. A method according to Claim 1,
**wherein**

said first electrode layer (12) consists of a transparent, conductive oxide and is structured by melting and immediately cooling parallel strip areas (14, 16).

7. A method according to at least one of the preceeding claims,
**wherein**
the structuring of the first electrode layer (12) and the depositing of the subsequent structural material are carried out simultaneously by means of a tool (82, 84).

8. A method according to Claim 1,
**wherein**
$TiO_2$ is used as an additional structural material.

9. A method according to Claim 1,
**wherein**
the first electrode layer (12) is structured by spark erosion.

## Revendications

1. Procédé de fabrication de cellules solaires (46, 48, 50) en couche mince, branchées en série et portées par un substrat (10) commun, selon lequel on réalise en grande surface sur le substrat, successivement une première couche (12) formant électrode, au moins une couche (34) en un matériau semiconducteur et une seconde couche (32) formant électrode, la première couche formant électrode étant structurée avant la mise en place des autres couches, procédé caractérisé en ce que simultanément ou postérieurement à la réalisation de la structure de la première couche (12) formant électrode, on applique sur cette couche, parallèlement à sa structure, une bande (28, 30) en un autre matériau de structure et sélectivement une bande (24, 26) en un matériau conducteur d'électricité, pour être recouverte par les autres couches (32, 34), et en ce qu'on enlève la bande de cet autre matériau de structure avec au moins une couche semi-conductrice (34) portée par cette bande et la seconde couche (32) formant électrode et en ce qu'enfin, pour le branchement des cellules solaires en couche mince, on réalise une liaison de la seconde couche formant électrode à la première couche formant électrode ou avec la bande prévue sélectivement en un matériau conducteur d'électricité à travers les autres couches.

2. Procédé selon la revendication 1, caractérisé en ce que le matériau conducteur d'électricité est une pâte comme par exemple une pâte de cuisson en argent ayant une température de cuisson de 400-460°C.

3. Procédé selon la revendication 1, caractérisé en ce que le matériau de structure pour réaliser la structure de la couche semi-conductrice (34) et de la seconde couche formant électrode (32) est une pâte fortement ohmique qui est mise en oscillation de préférence par des ultra-sons pour que les zones de la couche du matériau semi-conducteur se trouvant pardessus et la seconde couche formant électrode soient détruites.

4. Procédé selon la revendication 1, caractérisé en ce qu'on réalise le contact traversant du matériau conducteur d'électricité jusqu'à la seconde couche formant électrode (32) par érosion.

5. Procédé selon la revendication 1, caractérisé en ce que le matériau conducteur d'électricité et le matériau de structure réalisant la structure de la couche (34) du matériau semi-conducteur et de la seconde couche formant électrode (32) sont prévus de manière juxtaposée avec le cas échéant un chevauchement partiel sur la première couche formant électrode et sont mis en place de préférence simultanément.

6. Procédé selon la revendication 1, caractérisé en ce que la première couche formant électrode (12) est en un oxyde conducteur transparent et est structurée par fusion de zones en forme de bandes (14, 16) parallèles suivies immédiatement d'un refroidissement.

7. Procédé selon au moins l'une des revendications précédentes, caractérisé en ce que la réalisation de la structure de la première couche formant électrode (12) et l'application d'un matériau de structure servant à la structuration consécutive sont appliquées à l'aide d'un même outil (82, 84).

8. Procédé selon la revendication 1, caractérisé en ce que comme autre matériau de structure, on utilise une pâte $TiO_2$.

9. Procédé selon la revendication 1, caractérisé en ce qu'on réalise la structure de la première couche formant électrode (12) par étincelage.

**FIG.1**

**FIG.2**

FIG.3

FIG.4

8